# EUROPÄISCHE PATENTSCHRIFT

(11) **EP 2 824 158 B1**
(45) Veröffentlichungstag und Bekanntmachung des Hinweises auf die Patenterteilung: **10.05.2017**
(21) Anmeldenummer: 14160267.2
(22) Anmeldetag: 17.03.2014
(51) Int. Cl.: C09K 11/00, H01B 1/00

(54) **Halbleitendes Copolymer sowie Verfahren zu dessen Herstellung, Stoffgemisch, elektrisches oder elektronisches Bauelement sowie Verfahren zu dessen Herstellung**
Semiconducting copolymer and method for the production thereof, mixture of substances, electric or electronic component and method for producing the same
Copolymère semi-conducteur et son procédé de fabrication, mélange de substances, composant électrique ou électronique et son procédé de fabrication

(30) Priorität: 12.04.2013 DE 102013206586
(43) Veröffentlichungstag der Anmeldung: 14.01.2015
(73) Patentinhaber: Fraunhofer-Gesellschaft zur Förderung der angewandten Forschung e.V., 80686 München (DE)
(72) Erfinder: Janietz, Silvia, 14532 Stahnsdorf (DE); Katholing, Eileen, 14473 Potsdam (DE); Lange, Alexander, 14467 Potsdam (DE)
(74) Vertreter: Pfenning, Meinig & Partner mbB

(56) Entgegenhaltungen:
- EP-B1- 1 257 611
- WO-A1-01/62869
- WO-A1-2011/060526
- WO-A1-2012/029675
- WO-A1-2013/005564
- WO-A2-03/020790
- CN-A- 102 816 302
- CN-A- 102 827 357
- CN-A- 102 838 732
- CN-A- 102 850 529
- DE-A1-102010 032 737
- JP-A- 2011 124 551
- US-A1- 2007 014 939
- ANDREW C GRIMSDALE ET AL: "Synthesis of Light-Emitting Conjugated Polymers for Applications in Electroluminescent Devices", CHEMICAL REVIEWS, AMERICAN CHEMICAL SOCIETY, US, Bd. 109, 1. Februar 2009 (2009-02-01), Seiten 897-1091, XP009133687, ISSN: 0009-2665, DOI: 10.1021/CR000013V
- JUNWU CHEN AND YONG CAO: "Development of Novel Conjugated Donor Polymers for High-Efficiency Bulk-Heterojunction Photovoltaic Devices", ACCOUNTS OF CHEMICAL RESEARCH, ACS, WASHINGTON, DC, US, Bd. 42, Nr. 11, 17. November 2009 (2009-11-17), Seiten 1709-1718, XP002545095, ISSN: 0001-4842, DOI: 10.1021/AR900061Z [gefunden am 2009-07-02]
- DESTA GEDEFAW ET AL: "Alternating copolymers of fluorene and donor-acceptor-donor segments designed for miscibility in bulk heterojunction photovoltaics", JOURNAL OF MATERIALS CHEMISTRY, Bd. 19, Nr. 30, 15. April 2009 (2009-04-15), Seiten 5359-5363, XP055151796, GB ISSN: 0959-9428, DOI: 10.1039/b823137k
- JUNG-HSUN TSAI ET AL: "New thiophene-phenylene-thiophene acceptor random conjugated copolymers for optoelectronic applications", JOURNAL OF POLYMER SCIENCE PART A: POLYMER CHEMISTRY, Bd. 48, Nr. 11, 26. April 2010 (2010-04-26), Seiten 2351-2360, XP055151863, US ISSN: 0887-624X, DOI: 10.1002/pola.24002
- ZHI GAO ET AL: "A fluorine-functionalized alternating polymer with benzo[1,2-b:4,5-b']dithiophene and quinoxaline segments for photovoltaic devices", SYNTHETIC METALS, Bd. 172, 1. Mai 2013 (2013-05-01), Seiten 69-75, XP055152141, CH ISSN: 0379-6779, DOI: 10.1016/j.synthmet.2013.04.006
- HSIEH-CHIH CHEN ET AL: "Prominent Short-Circuit Currents of Fluorinated Quinoxaline-Based Copolymer Solar Cells with a Power Conversion Efficiency of 8.0%", CHEMISTRY OF MATERIALS, Bd. 24, Nr. 24, 4. Dezember 2012 (2012-12-04), Seiten 4766-4772, XP055151844, US ISSN: 0897-4756, DOI: 10.1021/cm302861s
- HONGMEI QIN ET AL: "Donor-acceptor (donor) polymers with differently conjugated side groups at the acceptor units for photovoltaics", JOURNAL OF POLYMER SCIENCE PART A: POLYMER CHEMISTRY, Bd. 51, Nr. 7, 5. Januar 2013 (2013-01-05) , Seiten 1565-1572, XP055151842, US ISSN: 0887-624X, DOI: 10.1002/pola.26526
- YUANHE FU ET AL: "Low-bandgap quinoxaline-based D-A-type copolymers: Synthesis, characterization, and photovoltaic properties", JOURNAL OF POLYMER SCIENCE PART A: POLYMER CHEMISTRY, Bd. 51, Nr. 2, 19. Oktober 2012 (2012-10-19), Seiten 372-382, XP055151845, US ISSN: 0887-624X, DOI: 10.1002/pola.26395
- RUOMENG DUAN ET AL: "Application of Two-Dimensional Conjugated Benzo[1,2- b :4,5- b ']dithiophene in Quinoxaline-Based Photovoltaic Polymers", MACROMOLECULES, Bd. 45, Nr. 7, 20. März 2012 (2012-03-20), Seiten 3032-3038, XP055151846, US ISSN: 0024-9297, DOI: 10.1021/ma300060z
- WU HAIMEI ET AL: "A copolymer based on benzo[1,2-b:4,5-b']dithiophene and quinoxaline derivative for photovoltaic application", REACTIVE & FUNCTIONAL POLYMERS, Bd. 72, Nr. 11, 1. Januar 2011 (2011-01-01), Seiten 897-903, XP028939810, ISSN: 1381-5148, DOI: 10.1016/J.REACTFUNCTPOLYM.2012.07.006
- PO-I LEE ET AL: "New conjugated copolymers based on benzo[1,2-b; 3,4-b']dithiophene and derivatives of benzo[g]quinoxaline for bulk heterojunction solar cells", JOURNAL OF POLYMER SCIENCE PART A: POLYMER CHEMISTRY, Bd. 49, Nr. 3, 1. Februar 2011 (2011-02-01), Seiten 662-670, XP055133516, ISSN: 0887-624X, DOI: 10.1002/pola.24477
- LETIAN DOU ET AL: "Synthesis of 5 H -Dithieno[3,2- b :2',3'- d ]pyran as an Electron-Rich Building Block for Donor-Acceptor Type Low-Bandgap Polymers", MACROMOLECULES, Bd. 46, Nr. 9, 26. April 2013 (2013-04-26) , Seiten 3384-3390, XP055152143, US ISSN: 0024-9297, DOI: 10.1021/ma400452j
- RUVINI S. KULARATNE ET AL: "Structural variation of donor-acceptor copolymers containing benzodithiophene with bithienyl substituents to achieve high open circuit voltage in bulk heterojunction solar cells", JOURNAL OF MATERIALS CHEMISTRY A. MATERIALS FOR ENERGY AND SUSTAINABILITY, Bd. 1, Nr. 48, 1. Januar 2013 (2013-01-01) , Seiten 15535-15543, XP055152135, UK ISSN: 2050-7488, DOI: 10.1039/c3ta13686h
- LU XIAO ET AL: "Fluorine substituted benzothiazole-based low bandgap polymers for photovoltaic applications", RSC ADVANCES: AN INTERNATIONAL JOURNAL TO FURTHER THE CHEMICAL SCIENCES, Bd. 3, Nr. 29, 1. Januar 2013 (2013-01-01) , Seiten 11869-11876, XP055152136, GB ISSN: 2046-2069, DOI: 10.1039/c3ra41140k
- STEVE ALBRECHT ET AL: "Fluorinated Copolymer PCPDTBT with Enhanced Open-Circuit Voltage and Reduced Recombination for Highly Efficient Polymer Solar Cells", JOURNAL OF THE AMERICAN CHEMICAL SOCIETY, Bd. 134, Nr. 36, 6. August 2012 (2012-08-06), Seiten 14932-14944, XP055152146, ISSN: 0002-7863, DOI: 10.1021/ja305039j
- YONGXI LI ET AL: "Side-Chain Effect on Cyclopentadithiophene/Fluorobenzothiadiazo le-Based Low Band Gap Polymers and Their Applications for Polymer Solar Cells", MACROMOLECULES, Bd. 46, Nr. 14, 28. Juni 2013 (2013-06-28) , Seiten 5497-5503, XP055152139, US ISSN: 0024-9297, DOI: 10.1021/ma4009302
- YONG ZHANG ET AL: "Significant Improved Performance of Photovoltaic Cells Made from a Partially Fluorinated Cyclopentadithiophene/Benzothiadiazole Conjugated Polymer", MACROMOLECULES, Bd. 45, Nr. 13, 22. Juni 2012 (2012-06-22) , Seiten 5427-5435, XP055152157, US ISSN: 0024-9297, DOI: 10.1021/ma3009178

## Beschreibung

Die vorliegende Erfindung betrifft die Herstellung von Copolymeren, insbesondere von Terpolymeren, basierend auf Cyclopentadithiophen-Monomeren, welche mit Donor-Akzeptormonomereinheiten und Akzeptoreinheiten verknüpft werden und ihre Anwendung als Halbleiter in organischen, elektronischen Bauteilen, insbesondere in der organischen Photovoltaik.

In den letzten Jahren bestand ein wachsendes Interesse in der Nutzung von konjugierten Polymeren in elektronischen Anwendungen. Ein Gebiet von großer Bedeutung ist die organische Photovoltaik (OPV). Es wurden Polymere gefunden, die sich aus Lösung zu dünnen homogenen Filmen verarbeiten lassen. Dazu werden Spin coating, Dipp coating oder Druckverfahren, wie "ink jet" oder "slot die coating" herangezogen. Die Lösungsprozessierung erlaubt eine deutlich billigere Herstellung und eine einfache Beschichtung von großen Flächen im Vergleich zu der Aufdampftechnologie für die Produktion von anorganischen Dünnfilm-Bauteilen. Polymer basierte photovoltaische Zellen erreichen heute Effizienzen um 9%.

Das konjugierte Polymer dient als Hauptabsorber der Solarenergie. Aus diesem Grund ist ein Polymer geeignet, welches eine Absorption über den gesamten Bereich des Sonnenspektrums gestattet. Eine Möglichkeit ist der Einsatz eines Polymeren mit optimiertem Bandgap. Ein Weg besteht darin, das Bandgap zu reduzieren, so dass man alternierende Copolymere herstellt, die sowohl Elektronen reiche Donor- als auch Elektronen arme Akzeptor-Einheiten in der polymeren Kette enthalten. 2,1,3-Benzothiadiazole sind solche Akzeptoreinheiten, die bekanntermaßen als Cocomponente eingesetzt werden und gute photovoltaische Eigenschaften aufweisen (J. Chen, Y. Cao, Acc. Chem. Res. 2009, 42, 1709; US 2010/0180944 A1).

Diese Polymere haben aber das Problem der begrenzten Löslichkeit in normalen organischen Lösungsmitteln. Einen Weg, die Löslichkeit der Copolymere zu erhöhen, wird in WO 2012/028246 A1 aufgezeigt. Durch das Einführen von Estergruppen in die 5- und 6-Position der Benzo-2,1,3-thidiazoleinheit können Alkylreste eingeführt werden, die die Löslichkeit des gesamten Copolymeren erhöhen, wobei aber der Nachteil entsteht, dass sich chinoide Strukturen in der polymeren Kette nicht mehr ausbilden können. Eine chinoide Struktur reduziert den Torsionswinkel zwischen den angrenzenden Ringen, woraus ein mehr planares Polymerrückgrat gebildet wird, das zu einer Ausweitung der effektiven Konjuagtionslänge und somit zu einer Reduzierung des Bandgaps und damit zu einer höheren Lichtabsorption führt. Es wurden auch Polymere hergestellt in denen 5,6-bis(Octyl)-benzo[2,1,3]thiadiazoleinheiten mit Fluoreneinheiten kombiniert wurden. (J. Bouffard, T.M. Swager, Macromolecules, 2008, 41, 5559).

Zusätzlich zu dieser Akzeptoreinheit wurden Thiophenringe integriert, um eine Donor-Akzeptoreinheit zu realisieren, die es auch ermöglicht, das Bandgap zu reduzieren (R. Qin, W. Li, C. Li, Du, C. Veit, H.-F. Schleiermacher, M. Andersson, Z. Bo, Z. Liu, O. Inganas, U. Wuerfel, F. Zhang, J. Am. Chem. Soc. 2009, 131, 14612, W. Li, R. Qin, Y. Zhou, M. Andersson, F. Li, C. Zhang, B. Li, Z. Liu, Z. Bo, F. Zhang, Polymer 2010, 51, 3031). Hierbei liegt das Maximum der Absorption bei circa 540 nm, die Lochmobilität des Polymeren fällt mit ca. 10⁻⁵ cm²/Vs sehr gering aus, was in einer photovoltaischen Zelle zu Effizienzen lediglich um die 3,0% führt.

Deshalb ist immer noch ein Bedarf an organischen halbleitenden Polymeren vorhanden, die sich leicht herstellen lassen, speziell auch für die Massenproduktion geeignet sind. Außerdem sollten diese gute filmbildende und elektronische Eigenschaften, insbesondere eine hohe Ladungsträgermobilität aufweisen. Sie sollten eine sehr gute Löslichkeit in organischen Lösungsmitteln und damit eine sehr gute Prozessierbarkeit und Luftstabilität aufzeigen. Hauptsächlich im Fall der OPV-Zellen sind halbleitende Polymere mit einem angepassten Bandgap für ein verbessertes Einsammeln der Photonen notwendig, welche dann zu höheren Zelleffizienzen führen kann.

Es ist somit Aufgabe der vorliegenden Erfindung, ein halbleitendes Polymer bzw. Copolymer bereitzustellen, das neben der hohen Ladungsträgerbeweglichkeit ein besser zum Sonnenspektrum angepasstes Absorptionsverhalten und eine sehr gute Löslichkeit in herkömmlichen organischen Lösungsmitteln aufweist.

Das halbleitende Polymer bzw. Copolymer soll insbesondere als halbleitender Bestandteil elektrischer oder elektronischer Bauelemente Anwendung finden. Zudem ist es Aufgabe der vorliegenden Erfindung, ein Stoffgemisch anzugeben, das ebenso die Absorber-Eigenschaften aufweist. Weiterhin soll gemäß der vorliegenden Erfindung ein entsprechendes elektrisches oder elektronisches Bauelement angegeben werden, das auf einem halbleitenden Polymer bzw. Copolymer basiert. Gemäß der vorliegenden Erfindung sollen ebenso Verfahren zur Herstellung des halbleitenden Polymers bzw. Copolymers und eines entsprechenden elektrischen oder elektronischen Bauelementes angegeben werden.

Diese Aufgabe wird bezüglich eines halbleitenden Copolymers mit den Merkmalen des Patentanspruchs 1, bezüglich eines Verfahrens zur Herstellung des Copolymers mit den Merkmalen des Patentanspruchs 7, bezüglich eines Stoffgemisches, enthaltend ein entsprechendes Copolymer mit den Merkmalen des Patentanspruchs 8, der Verwendung des Copolymers bzw. des Stoffgemisches mit den Merkmalen des Patentanspruchs 9, hinsichtlich eines elektrischen oder elektronischen Bauelements mit den Merkmalen des Patentanspruchs 10 sowie eines Verfahrens zur Herstellung des elektrischen oder elektronischen Bauelementes mit den Merkmalen des Patentanspruchs 15 gelöst.

Die jeweilig abhängigen Patentansprüche stellen dabei vorteilhafte Weiterbildungen dar.

Die vorliegende Erfindung betrifft somit ein Copolymer, umfassend
a) mindestens eine Dithiophen-Einheit 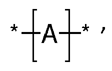 ausgewählt aus der Gruppe bestehend aus Cyclopentadithiophen-Einheiten 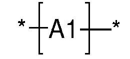 der nachfolgend abgebildeten Formeln 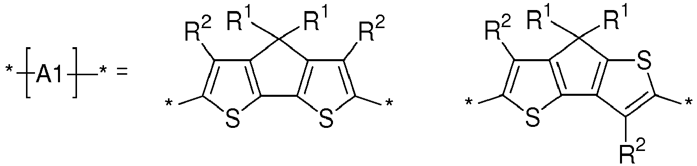 und/oder
   Benzodithiophen-Einheiten 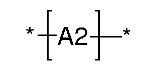 der nachfolgend abgebildeten Formeln 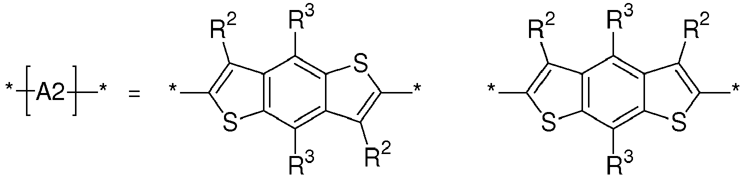
b) mindestens eine thiaaromatische Einheit 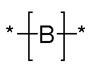 der nachfolgend abgebildeten Formel 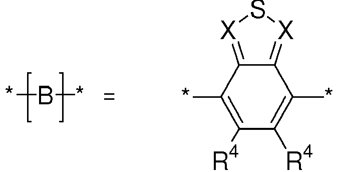 sowie
c) mindestens eine thiaaromatische Einheit 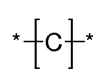 der nachfolgend abgebildeten Formel 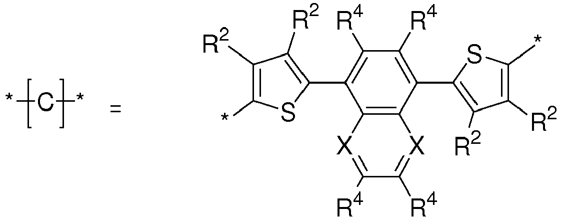 wobei in den angegebenen Formeln jeweils unabhängig voneinander
   - *: eine Verbindung zu einer benachbarten Einheit
   - R¹: bei jedem Auftreten jeweils gleich oder verschieden ist und einen Rest, ausgewählt aus der Gruppe bestehend aus Wasserstoff, linearen oder verzweigten Alkylresten mit 1 bis 36 Kohlenstoffatomen, Cycloalkylresten mit 5 bis 36 Kohlenstoffatomen, linearen oder verzweigten Alkoxyresten mit 1 bis 36 Kohlenstoffatomen, aromatischen Resten mit 6 bis 10 aromatischen Ringkohlenstoffatomen, Aryloxyresten mit 6 bis 36 Kohlenstoffatomen, Arylthiooxyresten mit 6 bis 36 Kohlenstoffatomen und heteroaromatischen Resten mit 4 bis 36 Kohlenstoffatomen,
   - R²: bei jedem Auftreten jeweils gleich oder verschieden ist und einen Rest, ausgewählt aus der Gruppe bestehend aus Wasserstoff, Fluor, linearen oder verzweigten Alkylresten mit 1 bis 36 Kohlenstoffatomen, Cycloalkylresten mit 5 bis 36 Kohlenstoffatomen, linearen oder verzweigten Alkoxyresten mit 1 bis 36 Kohlenstoffatomen, aromatischen Resten mit 6 bis 10 aromatischen Ringkohlenstoffatomen, Aryloxyresten mit 6 bis 36 Kohlenstoffatomen, Arylthiooxyresten mit 6 bis 36 Kohlenstoffatomen und heteroaromatischen Resten mit 4 bis 36 Kohlenstoffatomen,
   - R³: bei jedem Auftreten jeweils gleich oder verschieden ist und einen Rest, ausgewählt aus der Gruppe bestehend aus Wasserstoff, linearen oder verzweigten Alkylresten mit 1 bis 36 Kohlenstoffatomen, Cycloalkylresten mit 5 bis 36 Kohlenstoffatomen, linearen oder verzweigten Alkoxyresten mit 1 bis 36 Kohlenstoffatomen, Alkylthiooxylresten mit 1 bis 36 Kohlenstoffatomen, Oligo- oder Poly(alkylenglycol)oxy-Resten, aromatischen Resten mit 6 bis 10 aromatischen Ringkohlenstoffatomen, Aryloxyresten mit 6 bis 36 Kohlenstoffatomen, Arylthiooxyresten mit 6 bis 36 Kohlenstoffatomen und heteroaromatischen Resten mit 4 bis 36 Kohlenstoffatomen,
   - R⁴: bei jedem Auftreten jeweils gleich oder verschieden ist und einen Rest, ausgewählt aus der Gruppe bestehend aus Wasserstoff, Halogenen, linearen oder verzweigten Alkylresten mit 1 bis 36 Kohlenstoffatomen, Cycloalkylresten mit 5 bis 36 Kohlenstoffatomen, linearen oder verzweigten Alkoxyresten mit 1 bis 36 Kohlenstoffatomen, aromatischen Resten mit 6 bis 10 aromatischen Ringkohlenstoffatomen, Aryloxyresten mit 6 bis 36 Kohlenstoffatomen, Arylthiooxyresten mit 6 bis 36 Kohlenstoffatomen und heteroaromatischen Resten mit 4 bis 36 Kohlenstoffatomen, wobei zwei vicinale Reste R⁴ auch zu einem aromatischen oder heteroaromatischen Ringsystem verknüpft sein können,
   - X: bei jedem Auftreten jeweils gleich oder verschieden und Stickstoff oder Phosphor ist, bedeuten.

Das erfindungsgemäße Copolymer enthält somit zumindest die drei oben dargestellten, von den entsprechenden Monomeren abgeleiteten Einheiten A, B und C. Die jeweiligen Einheiten können im Copolymer auf beliebige Art und Weise angeordnet sein, z.B. statistisch verteilt vorliegen, als Blöcke verknüpft vorliegen oder alternierend angeordnet sein. Zudem ist es möglich, dass im Copolymer noch von weiteren Monomeren abgeleitete Einheiten vorhanden sind. In diesem Fall ist es bevorzugt, wenn die gegebenenfalls vorhandenen weiteren Einheiten zu den monomeren Einheiten A, B und C ein konjugiertes System bilden, so dass insgesamt ein halbleitendes Copolymer resultiert.

Das erfindungsgemäße Copolymer kann auf beliebige Art und Weise terminiert sein, beispielsweise mit Wasserstoff.

In einer besonders bevorzugten Ausführungsform sind die Reste R¹ dabei ausgewählt aus linearen oder verzweigten Alkylresten mit 1 bis 36 Kohlenstoffatomen, beispielsweise Hexyl-, Ethylhexyl-, Dimethyloctyl-Reste, oder Stellenalkoxy-Reste mit 1 bis 20 Kohlenstoffatomen dar, beispielsweise Alkoxy-Reste mit 1 bis 20 Kohlenstoffatome.

Besonders bevorzugt für die Reste R² sind dabei insbesondere Wasserstoff oder lineare oder verzweigte Alkylreste mit beispielsweise 1 bis 18 Kohlenstoffatomen.

Vorteilhafterweise sind die Reste R³ ausgewählt aus linearen oder verzweigten Alkylresten, wie beispielsweise Hexyl-, Ethylhexyl-, Dimethyloctyl-Resten, ebenso kommend bevorzugt C1 bis C20-Alkyloxyl-, Alkylthiooxyl-, oder Aryloxyl-, Arylthiooxyl-Reste in Frage. Ebenso können die Reste R³ aus Oligo-Ethern ausgewählt sein, wie beispielsweise Oligo(ethylenglykol)oxy-Resten.

Bei den Einheiten B sind die Reste R⁴ bevorzugt ausgewählt aus Wasserstoff und Halogenen, insbesondere Fluor. Hierbei ist es möglich, dass beide Reste R⁴ gleich sind, d.h. beispielsweise Wasserstoff oder Halogen, insbesondere Fluor sind, ebenso ist es möglich, dass die Reste R⁴ unterschiedlich sind, d.h. beispielsweise ein Rest R⁴ Wasserstoff, der andere Halogen, insbesondere Fluor darstellt.

Bei den Einheiten C sind bevorzugte Reste R⁴ Wasserstoff oder aromatische Reste, die weiter substituiert sein können, besonders bevorzugt in der meta-oder para-Position. Bevorzugte Substituenten an den aromatischen Resten stellen Alkoxyreste mit 1 bis 20 Kohlenstoffatomen dar, wie beispielsweise Ethylhexyl- oder Dimethyloctyl-Alkoxy-Gruppen.

Eine besonders bevorzugte Ausführungsform sieht vor, dass
die Reste R¹ ausgewählt sind aus linearen oder verzweigten Alkylresten mit 4 bis 20 Kohlenstoffatomen und/oder linearen oder verzweigten Alkoxyresten mit 4 bis 20 Kohlenstoffatomen und/oder
die Reste R³ ausgewählt sind aus linearen oder verzweigten Alkylresten mit 4 bis 20 Kohlenstoffatomen und/oder linearen oder verzweigten Alkoxyresten mit 4 bis 20 Kohlenstoffatomen und/oder
die Reste R⁴ der thiaaromatischen Einheit 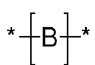 ausgewählt sind aus Wasserstoff und Halogenen, insbesondere Fluor, Chlor und Iod, und/oder
die Reste R⁴ des aromatischen sechsgliedrigen Ringes ohne Heteroatome der thiaaromatischen Einheit 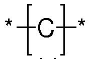 ausgewählt sind aus Wasserstoff und Halogenen, insbesondere Fluor, Chlor und Iod, und die Reste R⁴ des heteroaromatischen sechsgliedrigen Ringes der thiaaromatischen Einheit 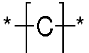 ausgewählt sind aus linearen oder verzweigten Alkylresten mit 4 bis 20 Kohlenstoffatomen.

Besonders bevorzugte Heteroatome X sind Stickstoff.

Gemäß einer weiter bevorzugten Ausführungsform ist das Copolymer aus den zuvor dargestellten Einheiten A, B und C gebildet, d.h. stellt ein Terpolymer dar.

Bei den erfindungsgemäßen Copolymeren ist es vorteilhaft, wenn der molare Anteil der Einheiten

| | |
|---|---|
| 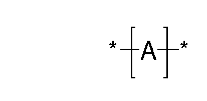 | zwischen 5 und 89,9 mol-%, bevorzugt zwischen 40 und 50 mol-%, |
| 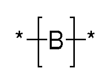 | zwischen 55 und 10 mol-%, bevorzugt zwischen 25 und 49 mol-%, und |
| 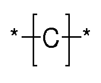 | zwischen 40 und 0,1 mol-%, bevorzugt zwischen 25 und 1 mol-%, |

beträgt, jeweils bezogen auf die Summe der molaren Anteile dieser Einheiten.

Gemäß einer weiter bevorzugten Ausführungsform liegen die Einheiten 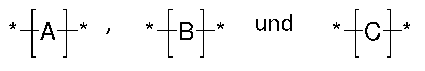 wie folgt verknüpft vor: 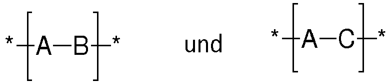 wobei *, A, B und C die zuvor genannte Bedeutung aufweisen.

Bei einer zuvor genannten Ausführungsform ist es vorteilhaft, wenn der molare Anteil der Einheit 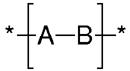 zwischen 99 und 30 mol-%, bevorzugt 95 bis 40 mol-%, besonders bevorzugt von 92,5 bis 75 mol-% und der molare Anteil der Einheit 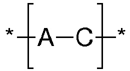 zwischen 1 und 70 mol-%, bevorzugt zwischen 5 und 60 mol-%, besonders bevorzugt von 7,5 und 25 mol-%, bezogen auf die Summe der beiden Einheiten 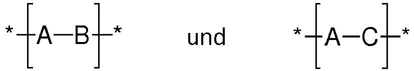 beträgt.

Eine besonders bevorzugte tieraromatische Einheit C ist mit der nachfolgend dargestellten Formel angegeben: 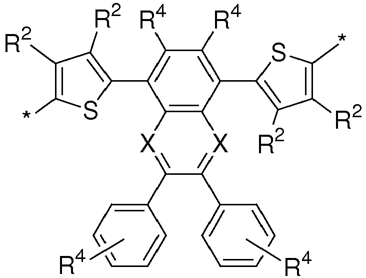 wobei *, R², R⁴ und x die zuvor genannte Bedeutung aufweisen

Die in der zuvor dargestellten Formel enthaltenen Aryl-Substituenten sind dabei insbesondere in der para- oder meta-Position mit den angegebenen Resten R⁴ substituiert.

Gemäß einem weiteren Aspekt betrifft die vorliegende Erfindung ein Verfahren zur Herstellung eines Copolymeren nach einem der vorhergehenden Ansprüche bei dem
a) eine Verbindung 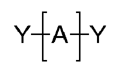 mit einem Gemisch der Verbindungen 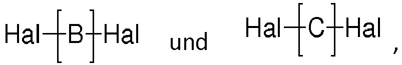 oder
b) eine Verbindung 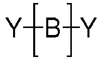 mit einem Gemisch der Verbindungen 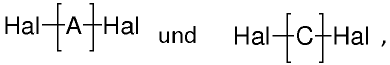 oder
c) eine Verbindung 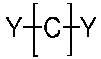 mit einem Gemisch der Verbindungen 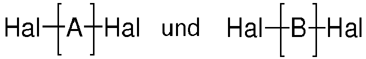
unter Einfluss eines Katalysators mittels Kreuzkupplung polymerisiert wird, wobei
- Hal: Cl, Br, I oder ein Pseudohalogen, wie z.B. Triflat oder Tosylat, und
- Y: Stannyl-, Boronsäure-, Boronsäureester-Gruppen oder-Zn-Hal
bedeuten.

Mögliche Kreuzkupplungs-Polymerisationen, die zur Herstellung des erfindungsgemäßen Copolymers eingesetzt werden können, sind insbesondere die Stille-, Suzuki- oder Negishi-Kreuzkupplungspolymerisation. Derartige Reaktionstypen sind aus dem Stand der Technik bekannt, die jeweiligen Bedingungen für derartige Reaktionstypen orientieren sich somit anhand der eingesetzten Halogenide bzw. Kreuzkupplungsreagenzien (Stanyl-, Boronsäure-, Boronsäureester- oder Zink-Gruppierungen).

Zudem betrifft die vorliegende Erfindung ein Stoffgemisch, umfassend ein zuvor beschriebenes erfindungsgemäßes Copolymer sowie mindestens ein C₆₀- und/oder C₇₀-Fulleren und/oder ein hiervon abgeleitetes Fullerenderivat, insbesondere PC₆₁BM und/oder PC₇₁BM, insbesondere in einem Gewichtsverhältnis (Copolymer : C₆₀- und/oder C₇₀-Fulleren und/oder ein hiervon abgeleitetes Fullerenderivat) von 10 : 90 und 80 : 20, bevorzugt von 20 : 80 und 70 : 30. Gängige und besonders bevorzugte Mischungen aus den erfindungsgemäßen Copolymeren und den Fullerenen bzw. den -derivaten weisen dabei ein Gewichtsverhältnis Copolymere : Fullerenen bzw. -derivaten von beispielsweise 1 : 0,5, 1 : 1, 1 : 2, 1 : 3 oder 1 : 4 auf.

Die Erfindung gibt zudem Verwendungszwecke des erfindungsgemäßen Copolymers oder des erfindungsgemäßen Stoffgemisches an, das sich gemäß der vorliegenden Erfindung als Absorber eines organischen Photovoltaikmoduls oder als halbleitender Bestandteil eines Feldeffekttransistors oder einer Diode eignet.

Zudem betrifft die vorliegende Erfindung ein elektrisches oder elektronisches Bauelement, das einen Halbleiter beinhaltet, der ein erfindungsgemäßes Copolymer oder ein erfindungsgemäßes Stoffgemisch wie voranstehend beschrieben enthält oder hieraus besteht.

Bevorzugt umfasst das erfindungsgemäße Bauelement
a) ein Substrat, bevorzugt aus Glas oder polymeren Materialien, wie z.B. Polyimiden, Polyalkylenen oder Polyestern,
b) eine auf dem Substrat abgeschiedene erste Elektrode, bevorzugt eine Elektrode aus Indium-Zinn-Oxid (ITO), Zinkoxid oder Titanoxid"
c) eine auf der ersten Elektrode abgeschiedene Schicht des Copolymers oder des Stoffgemischs, sowie
d) eine auf der Schicht des Copolymers oder des Stoffgemischs abgeschiedene zweite Elektrode, bevorzugt eine Elektrode aus LiF/Al, Ca, PEDOT:PSS oder Molybdänoxid,
e) sowie ggf. eine auf der zweiten Elektrode abgeschiedenen Schutzschicht.

Das erfindungsgemäße Bauelement kann beispielsweise eine transparente Elektrode aus ITO als erste Elektrode umfassen, die in diesem Fall die Anode darstellt. Für ein derartiges Bauelement eignen sich insbesondere LiF/Al oder Ca als Materialien für die zweite Elektrode, die in diesem Fall dann die Kathode darstellt. Ein derartiger Aufbau eines Bauelements wird "normaler Aufbau" bezeichnet.

Ebenso ist jedoch ein "invertierter Aufbau" des Bauelements denkbar und erfindungsgemäße ebenso vorteilhaft. In diesem Fall ist die erste Elektrode z.B. aus Zinkoxid oder Titanoxid gebildet und stellt die Kathode dar. Für die zweite Elektrode, die in diesem Fall die Anode bildet sind z.B. Materialien wie PEDOT:PSS oder Molybdänoxid denkbar. Diese Anodenmaterialien können auf der dem Copolymer abgewandten Seite bevorzugt mit einem leitenden Metall, wie z.B. Aluminium oder Silber beschichtet sein.

Weiter bevorzugt ist das Substrat des Bauelementes transparent, d.h. für Licht in einem Wellenlängenbereich zwischen 400 und 850 nm zumindest teilweise durchlässig.

Zudem kann bei dem erfindungsgemäßen Bauelement vorgesehen sein, dass zwischen der ersten Elektrode und der Schicht des Copolymers oder des Stoffgemischs eine Schicht eines leitenden Polymers abgeschieden ist, insbesondere PEDOT:PSS.

Beim erfindungsgemäßen Bauelement ist es ferner bevorzugt, dass
a) die Schicht des Copolymers oder des Stoffgemischs eine Schichtdicke von 20 nm bis 1000 nm, bevorzugt von 50 nm bis 500 nm,
b) die Schicht des leitenden Polymers eine Schichtdicke von 10 und 100 nm, bevorzugt von 20 bis 50 nm, und/oder
c) die erste und/oder zweite Elektrode eine Schichtdicke von 10 bis 1000 nm, bevorzugt von 50 bis 500 nm,
aufweist.

Insbesondere kann das erfindungsgemäße Bauelement in Form eines photovoltaischen Moduls, eines Feldeffekttransistors oder einer Diode aufweisen.

Die Erfindung betrifft weiterhin ein Verfahren zur Herstellung eines zuvor beschriebenen elektronischen Bauelementes, bei dem
a) das eingangs beschriebene erfindungsgemäße Copolymer oder das eingangs beschriebene erfindungsgemäße Stoffgemisch aus einer Lösung mittels spin coating, dip coating, doctor blade coating oder mittels Druckverfahren, wie ink jet coating oder slot die coating abgeschieden und anschließend das Lösungsmittel entfernt wird, und/oder
b) die erste und/oder zweite Elektrode aufgedampft oder aufgedruckt oder aus Vorläuferverbindungen der Elektrodenmaterialien abgeschieden werden.

Beim Erzeugen der Elektrodenmaterialien aus Vorläuferverbindungen kommen z.B. nasschemische Verfahren zum Einsatz, bei denen eine *in-situ-*Generierung der Elektrodenmaterialien vorgenommen wird, wie z.B. Reduktionen von geeigneten Salzlösungen der jeweiligen Metalle oder oxidative Verfahren. Ebenso kommen chemische Gasabscheideverfahren (CVD) in Frage.

Die vorliegende Erfindung wird anhand der nachfolgenden Beispiele sowie Ausführungen näher beschrieben, ohne die vorliegende Erfindung allerdings auf die speziell dargestellten Parameter zu beschränken.

Die erfindungsgemäßen Terpolymere basieren auf Cyclopentadithiophen-Einheiten oder Benzodithiophen-Einheiten, welche mit Donor-AkzeptorMonomereinheiten oder Akzeptor-Einheiten verknüpft sind. Besonders bevorzugte Einheiten sind nachfolgend dargestellt.

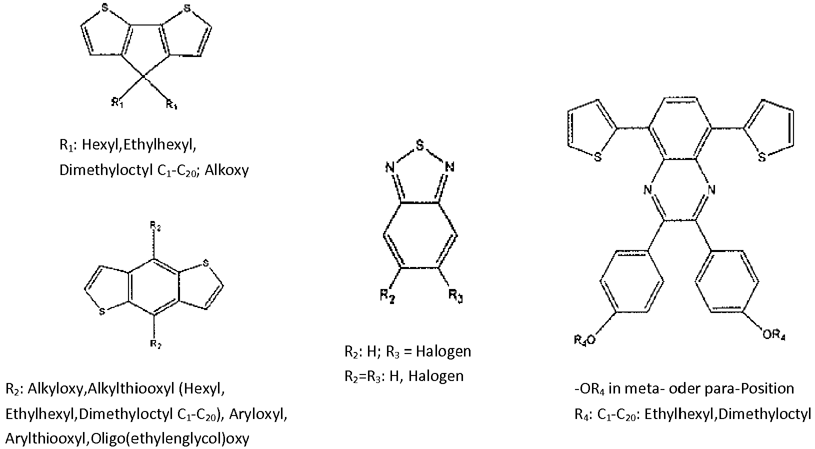

Überraschenderweise konnte festgestellt werden, dass durch das Einführen der zusätzlichen Donor-Akzeptoreinheit das Dithionylbisalkyloxyphenylchinoxalin-Derivat mit langen Alkoxyketten die Löslichkeit verbessert werden konnte ohne den Verlust der OPV Performance. Vorzugsweise werden die Terpolymere mittels Metall katalysierter Kupplungsreaktionen wie Stille oder Suzuki-Kupplung hergestellt. Dabei wird für das Cyclopentadithiophenderivat die difunktionellen Stannyl- oder die Diboronsäureester verwendet. Die Kupplungskomponenten sind dann die Dibromverbindungen des 2,1,3-Benzothiadiazolderivates und des Dithionylbisalkyloxyphenylchinoxalinderivates.

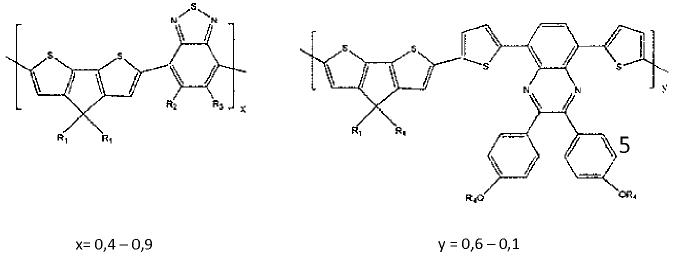

Das hergestellte Polymer kann als Halbleiter in einem elektrischen Bauelement verwendet werden. Das elektrische Bauelement kann ein organischer Feldeffekttransistor, eine Diode oder eine Photovoltaikzelle sein. Folgende Struktur wird bevorzugt aufgebaut: Als Substrat kann Glas, flexible Polymerfolien wie z.B. Polyimid, Polyethylen, Polyethylenterephthalat dienen. Auf dem Substrat wird eine transparente Elektrode wie ITO abgeschieden und darauf dann PEDOT-PSS z.B. mittels spin coating zur Anpassung der Energielagen aufgebracht. Das Terpolymer kann mit PC₆₁BM oder mit PC₇₁BM in einem organischen Lösungsmittel oder Gemischen gelöst und dieses Blend dann anschließend mittels spin coating oder Druckprozessen wie Ink-jet oder slot die coating abgeschieden werden. Darauf wird z.B. eine Kathode bestehend aus Lif/Al oder Ca aufgedampft.

### Monomerherstellung

Das 5,8-Di(5-bromthienyl-2,3-bis[4-octyloxyphenyl]chinoxalin wurde analog der Synthesevorschrift von A. Gadisa, W. Mammo, L.M. Andersson, S. Admassie, F. Zhang, M.R. Andersson, und O. Inganäs, Adv. Funct. Mat. 2007, 17, 3836-3842 hergestellt.

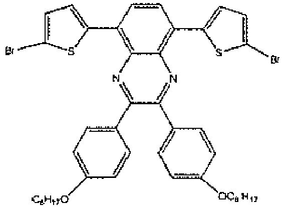

Das 4,7-Dibrom-5-fluor-2,1,3-benzothiadiazol wurde analog wie in der Literatur "St. Albrecht, S. Janietz, W. Schindler, J. Frisch, J. Kupers, J. Kiepert, S. inal, P. Pingel, K. Fostiropoulos, N. Koch, D. Neher, J. Am. Chem. Soc. 2012, 134, 14932 - 14944" beschrieben hergestellt.

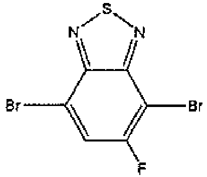

### Polymerisation

4,7-Dibrom-5-fluor-2,1,3-benzothiadiazol 301,7 mg (0,97 mmol), 5,8-Bis(5-bromthiophen-2-yl)-2,3-bis(4-octyloxyphenyl)quinoxalin 92,2 mg (0,11 mmol) und 4,4-bis(2-ethylhexyl)-2,6-bis(trimethylstannyl)-4H-cyclopenta[2,1-b:3,4-benzo-thiadiazol 900 mg (1,24 mmol) und 6ml p-Xylol, in welchen der Katalysator Pd(PPH)₃)₄ 30 mg gelöst war, wurden zusammen in der Glovebox in ein Mikrowellengefäß gegeben. Das Mikrowellengefäß wurde verschlossen, heraussgenommen und in die Mikrowelle plaziert. Dabei wurden die folgenden Reaktionsbedingungen genutzt: 120°C für 5 Minuten, 140°C für 5 Minuten und 170°C für 40 Minuten. Anschließend wurde die Reaktionslösung abgekühlt auf 60°C und in 300 ml Methanol ausgefällt. Das Polymer wurde in Chloroform gelöst (200 ml) und mit einer wässrigen Lösung Natriumdiethyldithiocarbamat trihydrat (10g in 200 ml destilliertem Wasser) versetzt. Das Gemisch wurde intensiv über Nacht bei 80°C gerührt. Die organische Phase wurde abgetrennt und dreimal mit Wasser gewaschen und über Magnesiumsulfat getrocknet. Die Polymerlösung wurde etwas eingeengt und in Methanol ausgefällt. Nach dem Trocknen des Polymers wurde dieses mit Methanol (12 Std.), Hexan (6 Std.), Dichlormethan (6 Std.) und Chloroform extrahiert und erneut in Methanol ausgefällt. Die Ausbeute betrug 30%. Poly[2,6-(4,4-bis(2-ethyl-hexyl)-4H-cyclopenta[2,1-b; 3,4-b]dithiophen)-alt-4,7-(2,1,3-benzothiadiazol)-co-5,8-Bis(thiophen-2-yl)-2,3-bis(4-octyloxyphenyl)quinoxalin Mₙ = 10,1 KDa, M_{w} = 11,6 KDa, PDI = 1,15 in THF

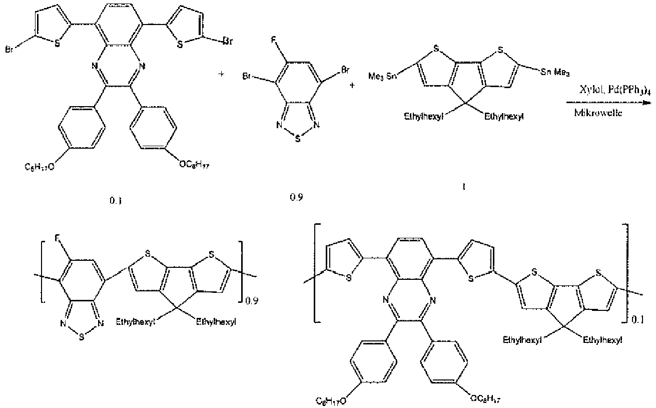

### Device-Herstellung und Charakterisierung

Bauteile wurden auf vorstrukturierten ITO-Gläsern (Optrex) aufgebaut. Diese wurden vorher mit Isopropanol gereinigt und anschließend mit einem Stickstoffstrom getrocknet. Eine 40 nm dicke Schicht PEDOT-PSS (Clevios Al 4083) wurde durch spin coating abgeschieden. Diese Schicht wurde in einer mit Stickstoff gefüllten Glovebox 15 Minuten bei 180°C getempert. Die aktive Schicht wurde durch spin coating aus einer Lösung, welche das Absorber Polymer und das PC₇₀BM (99% Solenne) in einem Verhältnis von 1:3 (Gewicht%) enthielt, hergestellt Chlorbenzol wurde als Lösungsmittel verwendet, welches 1 Volumen-% von Dijodoctan enthielt. Die totale Blendkonzentration war 36 mg/ml und das spin coating wurde bei unterschiedlichen Umdrehungsgeschwindigkeiten von 500 bis 2250 rpm für 30 Sekunden durchgeführt. Es wurden Schichtdicken von 70 - 150 nm realisiert. Anschließend wurden 0,6 nm LiF und 120 nm Al aufgedampft. Die aktive Fläche betrug 0,55 cm² . Diese wurde mit 100 mW/cm² beleuchtet. Die Stromdichte-Spannungscharakteristik erfolgte mit einem SMU von Kethley. Eine Silizium-Referenzelektrode mit einem KG3-Filter wurde verwendet, welche von Fraunhofer ISE calibriert wurde. Diese wurde genutzt, um die Intensität der Lichtquelle zu justieren, bevor die Polymer-Fulleren-Solarzellen vermessen wurden.

| **Substrat** | **Umdrehungsgeschwindigkeit (rpm)** | **Schichtdicke (nm)** | **Voc (V)** | **Jsc (mA/cm²)** | **FF (%)** | **PCE (%)** |
|---|---|---|---|---|---|---|
| | **550** | **153** | **0,695** | **9,34** | **53,9** | **3,50** |
| | **550** | **153** | **0,620** | **9,85** | **51,2** | **3,13** |
| | **1550** | **100** | **0,625** | **11,07** | **60,2** | **4,17** |
| | **1550** | **100** | **0,695** | **10,49** | **61,9** | **4,51** |
| | **2550** | **73** | **0,690** | **10,74** | **63,5** | **4,70** |
| | **2550** | **73** | **0,680** | **10,25** | **62,5** | **4,36** |

## Patentansprüche

1. Copolymer, umfassend
a) mindestens eine Dithiophen-Einheit 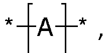 ausgewählt aus der Gruppe bestehend aus Cyclopentadithiophen-Einheiten 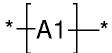 der nachfolgend abgebildeten Formeln 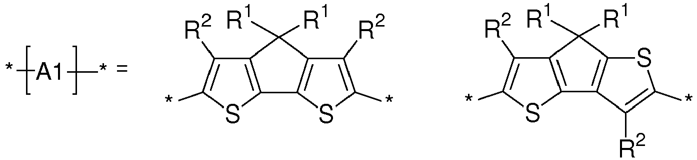 und/oder Benzodithiophen-Einheiten 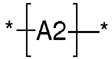 der nachfolgend abgebildeten Formeln 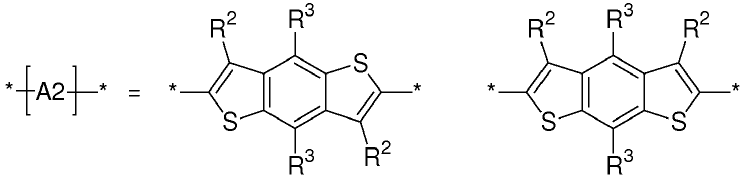
b) mindestens eine thiaaromatische Einheit 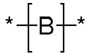 der nachfolgend abgebildeten Formel 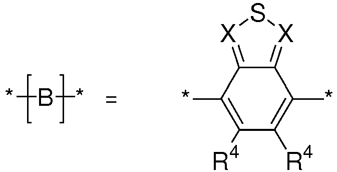 sowie
c) mindestens eine thiaaromatische Einheit 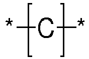 der nachfolgend abgebildeten Formel 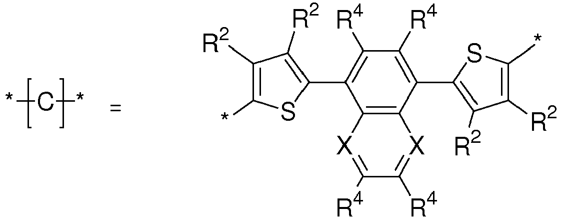 wobei in den angegebenen Formeln jeweils unabhängig voneinander
* eine Verbindung zu einer benachbarten Einheit
R¹ bei jedem Auftreten jeweils gleich oder verschieden ist und einen Rest, ausgewählt aus der Gruppe bestehend aus Wasserstoff, linearen oder verzweigten Alkylresten mit 1 bis 36 Kohlenstoffatomen, Cycloalkylresten mit 5 bis 36 Kohlenstoffatomen, linearen oder verzweigten Alkoxyresten mit 1 bis 36 Kohlenstoffatomen, aromatischen Resten mit 6 bis 10 aromatischen Ringkohlenstoffatomen, Aryloxyresten mit 6 bis 36 Kohlenstoffatomen, Arylthiooxyresten mit 6 bis 36 Kohlenstoffatomen und heteroaromatischen Resten mit 4 bis 36 Kohlenstoffatomen,
R² bei jedem Auftreten jeweils gleich oder verschieden ist und einen Rest, ausgewählt aus der Gruppe bestehend aus Wasserstoff, Fluor, linearen oder verzweigten Alkylresten mit 1 bis 36 Kohlenstoffatomen, Cycloalkylresten mit 5 bis 36 Kohlenstoffatomen, linearen oder verzweigten Alkoxyresten mit 1 bis 36 Kohlenstoffatomen, aromatischen Resten mit 6 bis 10 aromatischen Ringkohlenstoffatomen, Aryloxyresten mit 6 bis 36 Kohlenstoffatomen, Arylthiooxyresten mit 6 bis 36 Kohlenstoffatomen und heteroaromatischen Resten mit 4 bis 36 Kohlenstoffatomen,
R³ bei jedem Auftreten jeweils gleich oder verschieden ist und einen Rest, ausgewählt aus der Gruppe bestehend aus Wasserstoff, linearen oder verzweigten Alkylresten mit 1 bis 36 Kohlenstoffatomen, Cycloalkylresten mit 5 bis 36 Kohlenstoffatomen, linearen oder verzweigten Alkoxyresten mit 1 bis 36 Kohlenstoffatomen, Alkylthiooxylresten mit 1 bis 36 Kohlenstoffatomen, Oligo- oder Poly(alkylenglycol)oxy-Resten, aromatischen Resten mit 6 bis 10 aromatischen Ringkohlenstoffatomen, Aryloxyresten mit 6 bis 36 Kohlenstoffatomen, Arylthiooxyresten mit 6 bis 36 Kohlenstoffatomen und heteroaromatischen Resten mit 4 bis 36 Kohlenstoffatomen,
R⁴ bei jedem Auftreten jeweils gleich oder verschieden ist und einen Rest, ausgewählt aus der Gruppe bestehend aus Wasserstoff, Halogenen, linearen oder verzweigten Alkylresten mit 1 bis 36 Kohlenstoffatomen, Cycloalkylresten mit 5 bis 36 Kohlenstoffatomen, linearen oder verzweigten Alkoxyresten mit 1 bis 36 Kohlenstoffatomen, aromatischen Resten mit 6 bis 10 aromatischen Ringkohlenstoffatomen, Aryloxyresten mit 6 bis 36 Kohlenstoffatomen, Arylthiooxyresten mit 6 bis 36 Kohlenstoffatomen und heteroaromatischen Resten mit 4 bis 36 Kohlenstoffatomen, wobei zwei vicinale Reste R⁴ auch zu einem aromatischen oder heteroaromatischen Ringsystem verknüpft sein können,
X bei jedem Auftreten jeweils gleich oder verschieden und Stickstoff oder Phosphor ist,
bedeuten.

2. Copolymer nach Anspruch 1, **dadurch gekennzeichnet, dass**
die Reste R¹ ausgewählt sind aus linearen oder verzweigten Alkylresten mit 4 bis 20 Kohlenstoffatomen und/oder linearen oder verzweigten Alkoxyresten mit 4 bis 20 Kohlenstoffatomen und/oder
die Reste R³ ausgewählt sind aus linearen oder verzweigten Alkylresten mit 4 bis 20 Kohlenstoffatomen und/oder linearen oder verzweigten Alkoxyresten mit 4 bis 20 Kohlenstoffatomen und/oder
die Reste R⁴ der thiaaromatischen Einheit 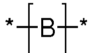 ausgewählt sind aus Wasserstoff und Halogenen, insbesondere Fluor, Chlor und Iod, und/oder
die Reste R⁴ eines aromatischen sechsgliedrigen Ringes ohne Heteroatome der thiaaromatischen Einheit 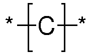 ausgewählt sind aus Wasserstoff und Halogenen, insbesondere Fluor, Chlor und Iod, und die Reste R⁴ eines heteroaromatischen sechsgliedrigen Ringes der thiaaromatischen Einheit 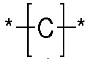 ausgewählt sind aus linearen oder verzweigten Alkylresten mit 4 bis 20 Kohlenstoffatomen.

3. Copolymer nach einem der vorhergehenden Ansprüche, **dadurch gekennzeichnet, dass** das Copolymer aus den Einheiten A, B und C gebildet ist oder
der molare Anteil der Einheiten
| | |
|---|---|
| 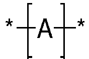 | zwischen 5 und 89,9 mol-%, bevorzugt zwischen 40 und 50 mol-%, |
| 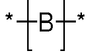 | zwischen 55 und 10 mol-%, bevorzugt zwischen 25 und 49 mol-%, und |
| 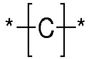 | zwischen 40 und 0,1 mol-%, bevorzugt zwischen 25 und 1 mol-%, |
beträgt, jeweils bezogen auf die Summe der molaren Anteile dieser Einheiten.

4. Copolymer nach einem der vorhergehenden Ansprüche, **dadurch gekennzeichnet, dass** die Einheiten 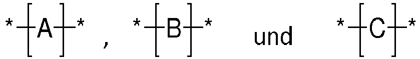 wie folgt verknüpft vorliegen 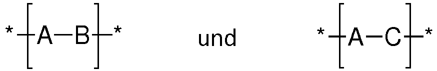 wobei *, A, B und C die in Anspruch 1 angegebene Bedeutung besitzen.

5. Copolymer nach vorhergehendem Anspruch, **dadurch gekennzeichnet, dass** der molare Anteil der Einheit 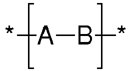 zwischen 99 und 30 mol-%, bevorzugt 95 bis 40 mol-%, besonders bevorzugt von 92,5 bis 75 mol-% und
der molare Anteil der Einheit 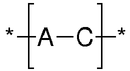 zwischen 1 und 70 mol-%, bevorzugt zwischen 5 und 60 mol-%, besonders bevorzugt von 7,5 und 25 mol-%, bezogen auf die Summe der beiden Einheiten 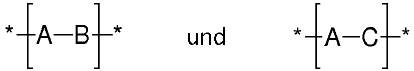 beträgt.

6. Copolymer nach einem der vorhergehenden Ansprüche, **dadurch gekennzeichnet, dass** die thiaaromatische Einheit C eine Gruppierung der nachfolgend abgebildeten Formel darstellt 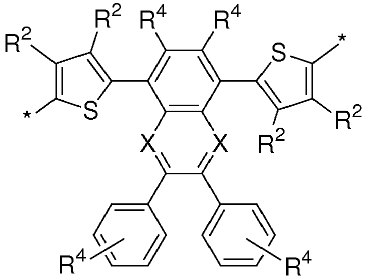 wobei *, R², R⁴ und X die zuvor genannte Bedeutung aufweisen.

7. Verfahren zur Herstellung eines Copolymeren nach einem der vorhergehenden Ansprüche bei dem
a) eine Verbindung 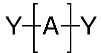 mit einem Gemisch der Verbindungen 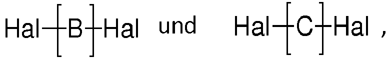 oder
b) eine Verbindung 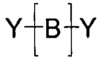 mit einem Gemisch der Verbindungen 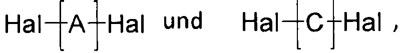 oder
c) eine Verbindung 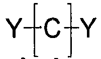 mit einem Gemisch der Verbindungen 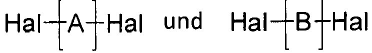 unter Einfluss eines Katalysators mittels Kreuzkupplung polymerisiert wird, wobei
Hal Cl, Br, I oder ein Pseudohalogen, wie z.B. Triflat oder Tosylat, und
Y Stannyl-, Boronsäure-, Boronsäureester-Gruppen oder-Zn-Hal bedeuten.

8. Stoffgemisch, umfassend ein Copolymer nach einem der Ansprüche 1 bis 6 sowie mindestens ein C₆₀- und/oder C₇₀-Fulleren und/oder ein hiervon abgeleitetes Fullerenderivat, insbesondere PC₆₁BM und/oder PC₇₁BM, insbesondere in einem Gewichtsverhältnis (Copolymer : C₆₀-und/oder C₇₀-Fulleren und/oder ein hiervon abgeleitetes Fullerenderivat) von 10 : 90 und 80 : 20, bevorzugt von 20 : 80 und 70 : 30.

9. Verwendung eines Copolymers nach einem der Ansprüche 1 bis 7 oder eines Stoffgemischs nach vorhergehendem Anspruch als Absorber eines organischen Photovoltaikmoduls oder als halbleitender Bestandteil eines Feldeffekttransistors oder einer Diode.

10. Elektrisches oder elektronisches Bauelement, umfassend einen Halbleiter, enthaltend oder bestehend aus einem Copolymer nach einem der Ansprüche 1 bis 6 oder einem Stoffgemisch nach Anspruch 8.

11. Bauelement nach vorhergehendem Anspruch, umfassend
a) ein Substrat, bevorzugt aus Glas oder polymeren Materialien, wie z.B. Polyimiden, Polyalkylenen oder Polyestern,
b) eine auf dem Substrat abgeschiedene erste Elektrode, bevorzugt eine Elektrode aus Indium-Zinn-Oxid (ITO), Zinkoxid oder Titanoxid,
c) eine auf der ersten Elektrode abgeschiedene Schicht des Copolymers oder des Stoffgemischs, sowie
d) eine auf der Schicht des Copolymers oder des Stoffgemischs abgeschiedene zweite Elektrode, bevorzugt eine Elektrode aus LiF/Al, Ca, PEDOT:PSS oder Molybdänoxid,
e) sowie ggf. eine auf der zweiten Elektrode abgeschiedenen Schutzschicht.

12. Bauelement nach einem der beiden vorhergehenden Ansprüche, **dadurch gekennzeichnet, dass** zwischen der ersten Elektrode und der Schicht des Copolymers oder des Stoffgemischs eine Schicht eines leitenden Polymers abgeschieden ist, insbesondere PEDOT:PSS.

13. Bauelement nach einem der beiden vorhergehenden Ansprüche, **dadurch gekennzeichnet, dass**
a) die Schicht des Copolymers oder des Stoffgemischs eine Schichtdicke von 20 nm bis 1000 nm, bevorzugt von 50 nm bis 500 nm,
b) die Schicht des leitenden Polymers eine Schichtdicke von 10 und 100 nm, bevorzugt von 20 bis 50 nm, und/oder
c) die erste und/oder zweite Elektrode eine Schichtdicke von 10 bis 1000 nm, bevorzugt von 50 bis 500 nm,
aufweist.

14. Bauelement nach einem der Ansprüche 11 bis 13 in Form eines photovoltaischen Moduls, eines Feldeffekttransistors oder einer Diode.

15. Verfahren zur Herstellung eines elektrischen oder elektronischen Bauelements nach einem der Ansprüche 11 bis 14, bei dem
a) das Copolymer nach einem der Ansprüche 1 bis 6 oder das Stoffgemisch nach Anspruch 8 aus einer Lösung mittels spin coating, dip coating, doctor blade coating oder mittels Druckverfahren, wie ink jet coating oder slot die coating abgeschieden und anschließend das Lösungsmittel entfernt wird, und/oder
b) die erste und/oder zweite Elektrode aufgedampft oder aufgedruckt oder aus Vorläuferverbindungen der Elektrodenmaterialien abgeschieden werden.

## Claims

1. A copolymer, comprising
a) at least one dithiophene unit 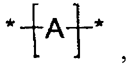 selected from the group consisting of cyclopentadithiophene units 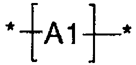 of the formulae illustrated below 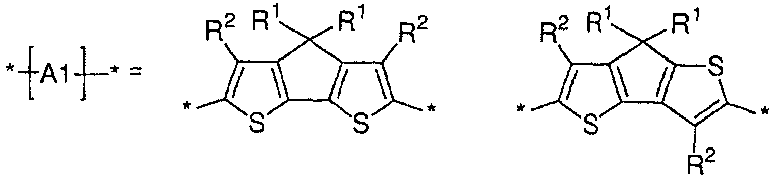 and/or
benzodithiophene units 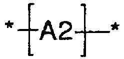 of the formulae illustrated below 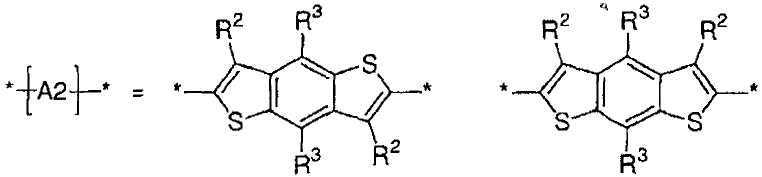
b) at least one thia-aromatic unit 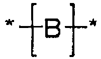 of the formula illustrated below 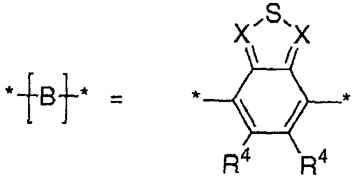 and also
c) at least one thia-aromatic unit 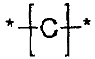 of the formula illustrated below 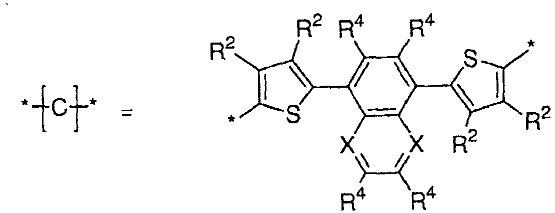 wherein in the formulae given in each case independently of each other
* is a link to an adjacent unit
R¹ for each occurrence is in each case identical or different and is a radical, selected from the group consisting of hydrogen, linear or branched alkyl radicals with 1 to 36 carbon atoms, cycloalkyl radicals with 5 to 36 carbon atoms, linear or branched alkoxy radicals with 1 to 36 carbon atoms, aromatic radicals with 6 to 10 aromatic ring carbon atoms, aryloxy radicals with 6 to 36 carbon atoms, aryl thiooxy radicals with 6 to 36 carbon atoms and heteroaromatic radicals with 4 to 36 carbon atoms,
R² for each occurrence is in each case identical or different and is a radical, selected from the group consisting of hydrogen, fluorine, linear or branched alkyl radicals with 1 to 36 carbon atoms, cycloalkyl radicals with 5 to 36 carbon atoms, linear or branched alkoxy radicals with 1 to 36 carbon atoms, aromatic radicals with 6 to 10 aromatic ring carbon atoms, aryloxy radicals with 6 to 36 carbon atoms, aryl thiooxy radicals with 6 to 36 carbon atoms and heteroaromatic radicals with 4 to 36 carbon atoms,
R³ for each occurrence is in each case identical or different and is a radical, selected from the group consisting of hydrogen, linear or branched alkyl radicals with 1 to 36 carbon atoms, cycloalkyl radicals with 5 to 36 carbon atoms, linear or branched alkoxy radicals with 1 to 36 carbon atoms, alkylthiooxyl radicals with 1 to 36 carbon atoms, oligo- or poly(alkylene glycol)oxy radicals, aromatic radicals with 6 to 10 aromatic ring carbon atoms, aryloxy radicals with 6 to 36 carbon atoms, aryl thiooxy radicals with 6 to 36 carbon atoms and heteroaromatic radicals with 4 to 36 carbon atoms,
R⁴ for each occurrence is in each case identical or different and is a radical, selected from the group consisting of hydrogen, halogens, linear or branched alkyl radicals with 1 to 36 carbon atoms, cycloalkyl radicals with 5 to 36 carbon atoms, linear or branched alkoxy radicals with 1 to 36 carbon atoms, aromatic radicals with 6 to 10 aromatic ring carbon atoms, aryloxy radicals with 6 to 36 carbon atoms, aryl thiooxy radicals with 6 to 36 carbon atoms and heteroaromatic radicals with 4 to 36 carbon atoms, wherein two vicinal radicals R⁴ may also be linked to form an aromatic or heteroaromatic ring system,
X for each occurrence is in each case identical or different and is nitrogen or phosphorus.

2. A copolymer according to Claim 1, **characterised in that**
the radicals R¹ are selected from linear or branched alkyl radicals with 4 to 20 carbon atoms and/or linear or branched alkoxy radicals with 4 to 20 carbon atoms, and/or the radicals R³ are selected from linear or branched alkyl radicals with 4 to 20 carbon atoms and/or linear or branched alkoxy radicals with 4 to 20 carbon atoms, and/or
the radicals R⁴ of the thia-aromatic unit 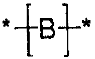 are selected from hydrogen and halogens, in particular fluorine, chlorine and iodine, and/or
the radicals R⁴ of an aromatic six-membered ring without heteroatoms of the thia-aromatic unit 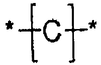 are selected from hydrogen and halogens, in particular fluorine, chlorine and iodine, and the radicals R⁴ of a heteroaromatic six-membered ring of the
thia-aromatic unit 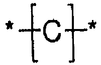 are selected from linear or branched alkyl radicals with 4 to 20 carbon atoms.

3. A copolymer according to one of the preceding claims, **characterised in that** the copolymer is formed from the units A, B and C, or
the molar proportion of the units is
| | |
|---|---|
| 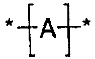 | between 5 and 89.9 mole %, preferably between 40 and 50 mole %, |
| 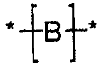 | between 55 and 10 mole %, preferably between 25 and 49 mole %, and |
| 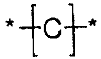 | between 40 and 0.1 mole %, preferably between 25 and 1 mole %, |
in each case relative to the total of the molar proportions of these units.

4. A copolymer according to one of the preceding claims, **characterised in that** the units 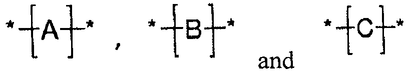 are present linked as follows 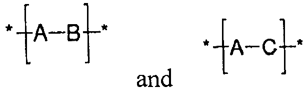 wherein *, A, B and C have the meaning given in Claim 1.

5. A copolymer according to the preceding claim, **characterised in that** the molar proportion of the unit 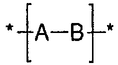 is between 99 and 30 mole %, preferably 95 to 40 mole %, particularly preferably from 92.5 to 75 mole %, and
the molar proportion of the unit 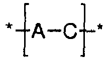 is between 1 and 70 mole %, preferably between 5 and 60 mole %, particularly preferably from 7.5 and 25 mole %, relative to the total of the two units

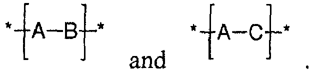

6. A copolymer according to one of the preceding claims, **characterised in that** the thia-aromatic unit C represents a grouping of the formula illustrated below 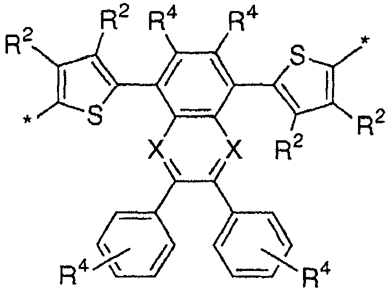 wherein *, R², R⁴ and X have the meaning previously stated.

7. A method for preparing a copolymer according to one of the preceding claims, in which
a) a compound 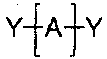 is polymerised with a mixture of the compounds 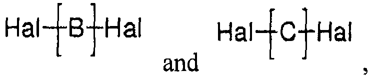 or
b) a compound 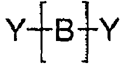 is polymerised with a mixture of the compounds 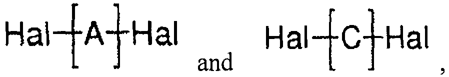 or
c) a compound 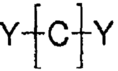 is polymerised with a mixture of the compounds 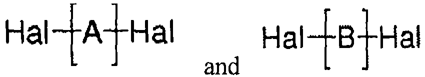 under the influence of a catalyst by means of cross-coupling, wherein
Hal is Cl, Br, I or a pseudohalogen, such as triflate or tosylate, and
Y is stannyl groups, boronic acid groups, boronic acid ester groups or -Zn-Hal.

8. A substance mixture, comprising a copolymer according to one of Claims 1 to 6 and also at least one C₆₀- and/or C₇₀-fullerene and/or a fullerene derivative derived therefrom, in particular PC₆₁BM and/or PC₇₁BM, in particular in a weight ratio (copolymer: C₆₀- and/or C₇₀-fullerene and/or a fullerene derivative derived therefrom) of 10 : 90 and 80 : 20, preferably of 20 : 80 and 70 : 30.

9. Use of a copolymer according to one of Claims 1 to 7 or of a substance mixture according to the preceding claim as an absorber of an organic photovoltaic module or as a semiconducting constituent of a field effect transistor or a diode.

10. An electrical or electronic component, comprising a semiconductor, containing or consisting of a copolymer according to one of Claims 1 to 6 or of a substance mixture according to Claim 8.

11. A component according to the preceding claim, comprising
a) a substrate, preferably made of glass or polymeric materials, such as polyimides, polyalkylenes or polyesters,
b) a first electrode deposited on the substrate, preferably an electrode made of indium tin oxide (ITO), zinc oxide or titanium oxide,
c) a layer of the copolymer or of the substance mixture deposited on the first electrode, and also
d) a second electrode deposited on the layer of the copolymer or of the substance mixture, preferably an electrode made of LiF/Al, Ca, PEDOT:PSS or molybdenum oxide,
e) and also optionally a protective layer deposited on the second electrode.

12. A component according to one of the preceding two claims, **characterised in that** a layer of a conductive polymer, in particular PEDOT:PSS, is deposited between the first electrode and the layer of the copolymer or of the substance mixture.

13. A component according to one of the preceding two claims, **characterised in that**
a) the layer of the copolymer or of the substance mixture has a layer thickness of 20 nm to 1000 nm, preferably of 50 nm to 500 nm,
b) the layer of the conductive polymer has a layer thickness of 10 and 100 nm, preferably of 20 to 50 nm, and/or
c) the first and/or second electrode has a layer thickness of 10 to 1000 nm, preferably of 50 to 500 nm.

14. A component according to one of Claims 11 to 13 in the form of a photovoltaic module, a field effect transistor or a diode.

15. A method for producing an electrical or electronic component according to one of Claims 11 to 14, in which
a) the copolymer according to one of Claims 1 to 6 or the substance mixture according to Claim 8 is deposited from a solution by means of spin coating, dip coating, doctor blade coating or by means of printing processes, such as ink jet coating or slot die coating and then the solvent is removed, and/or
b) the first and/or second electrode is/are vapour-deposited or printed or deposited from precursor compounds of the electrode materials.

## Revendications

1. Copolymère, comprenant
a) au moins un motif dithiophène 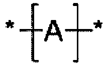 choisi dans le groupe consistant en les motifs cyclopentadithiophène 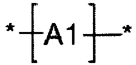 ayant les formules présentées ci-après 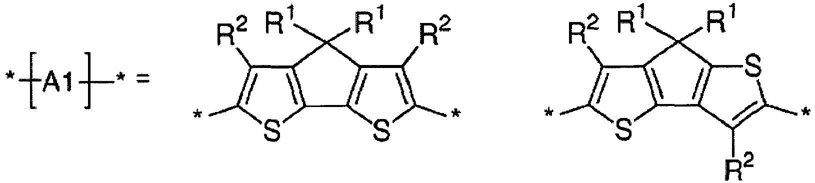 et/ou
les motifs benzodithiophène 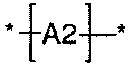 ayant les formules présentées ci-après 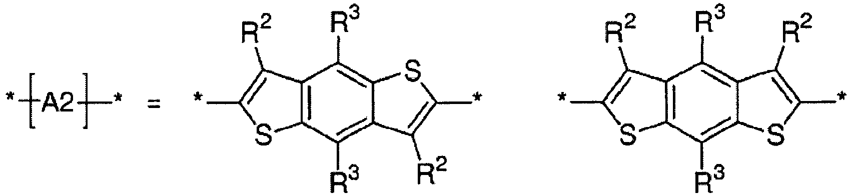
b) au moins un motif thiaaromatique 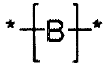 ayant la formule présentée ci-après 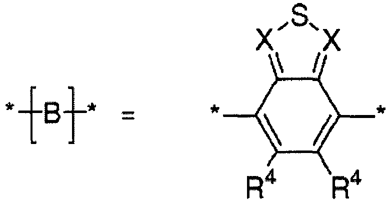 ainsi que
c) au moins un motif thiaaromatique 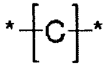 ayant la formule présentée ci-après 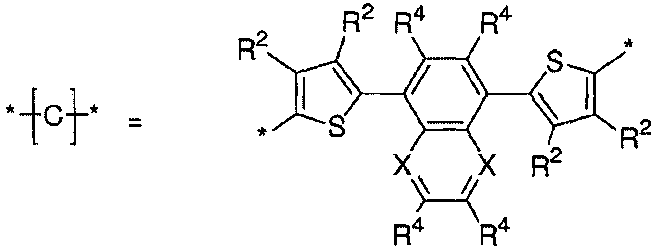 dans lequel, dans les formules indiquées, et chacun indépendamment des autres
* représente une liaison à un motif voisin,
R¹, à chaque occurrence, est dans chaque cas identique ou différent, et représente un radical choisi dans le groupe consistant en l'atome d'hydrogène, les radicaux alkyle à chaîne droite ou ramifiée ayant 1 à 36 atomes de carbone, les radicaux cycloalkyle ayant 5 à 36 atomes de carbone, les radicaux alcoxy à chaîne droite ou ramifiée ayant 1 à 36 atomes de carbone, les radicaux aromatiques ayant 6 à 10 atomes de carbone nucléaires aromatiques, les radicaux aryloxy ayant 6 à 36 atomes de carbone, les radicaux arylthiooxy ayant 6 à 36 atomes de carbone et les radicaux hétéroaromatiques ayant 4 à 36 atomes de carbone,
R², à chaque occurrence, est dans chaque cas identique ou différent, et représente un radical choisi dans le groupe consistant en l'atome d'hydrogène, le groupe fluoro, les radicaux alkyle à chaîne droite ou ramifiée ayant 1 à 36 atomes de carbone, les radicaux cycloalkyle ayant 5 à 36 atomes de carbone, les radicaux alcoxy à chaîne droite ou ramifiée ayant 1 à 36 atomes de carbone, les radicaux aromatiques ayant 6 à 10 atomes de carbone nucléaires aromatiques, les radicaux aryloxy ayant 6 à 36 atomes de carbone, les radicaux arylthiooxy ayant 6 à 36 atomes de carbone et les radicaux hétéroaromatiques ayant 4 à 36 atomes de carbone,
R³, à chaque occurrence, est dans chaque cas identique ou différent et représente un radical choisi dans le groupe consistant en l'atome d'hydrogène, les radicaux alkyle à chaîne droite ou ramifiée ayant 1 à 36 atomes de carbone, les radicaux cycloalkyle ayant 5 à 36 atomes de carbone, les radicaux alcoxy à chaîne droite ou ramifiée ayant 1 à 36 atomes de carbone, les radicaux alkylthiooxyle ayant 1 à 36 atomes de carbone, les radicaux oligo- ou poly(alkylèneglycol)oxy, les radicaux aromatiques ayant 6 à 10 atomes de carbone nucléaires aromatiques, les radicaux aryloxy ayant 6 à 36 atomes de carbone, les radicaux arylthiooxy ayant 6 à 36 atomes de carbone et les radicaux hétéroaromatiques ayant 4 à 36 atomes de carbone,
R⁴, à chaque occurrence, est dans chaque cas identique ou différent, et représente un radical choisi dans le groupe consistant en l'atome d'hydrogène, les groupes halogéno, les radicaux alkyle à chaîne droite ou ramifiée ayant 1 à 36 atomes de carbone, les radicaux cycloalkyle ayant 5 à 36 atomes de carbone, les radicaux alcoxy à chaîne droite ou ramifiée, ayant 1 à 36 atomes de carbone, les radicaux aromatiques ayant 6 à 10 atomes de carbone nucléaires aromatiques, les radicaux aryloxy ayant 6 à 36 atomes de carbone, les radicaux arylthiooxy ayant 6 à 36 atomes de carbone et les radicaux hétéroaromatiques ayant 4 à 36 atomes de carbone, deux radicaux voisins R⁴ pouvant aussi être reliés à un système cyclique aromatique ou hétéroaromatique,
X, à chaque occurrence, est dans chaque cas identique ou différent et est un atome d'azote ou de phosphore.

2. Copolymère selon la revendication 1, **caractérisé en ce que**
les radicaux R¹ sont choisis parmi les radicaux alkyle à chaîne droite ou ramifiée ayant 4 à 20 atomes de carbone et/ou les radicaux alcoxy à chaîne droite ou ramifiée ayant 4 à 20 atomes de carbone, et/ou
les radicaux R³ sont choisis parmi les radicaux alkyle à chaîne droite ou ramifiée ayant 4 à 20 atomes de carbone et/ou les radicaux alcoxy à chaîne droite ou ramifiée ayant 4 à 20 atomes de carbone, et/ou
les radicaux R⁴ du motif thiaaromatique 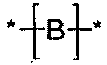 sont choisis parmi l'atome d'hydrogène et les groupes halogéno, en particulier fluoro, chloro et iodo, et/ou
les radicaux R⁴ d'un noyau aromatique à six chaînons sans hétéroatomes du motif thiaaromatique 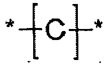 sont choisis parmi l'atome d'hydrogène et les groupes halogéno, en particulier fluoro, chloro et iodo, et les radicaux R⁴ d'un noyau hétéroaromatique à six chaînons du motif thiaaromatique 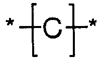 sont choisis parmi les radicaux alkyle à chaîne droite ou ramifiée ayant 4 à 20 atomes de carbone.

3. Copolymère selon l'une des revendications précédentes, **caractérisé en ce que** le copolymère est formé des motifs A, B et C, ou
la proportion en moles des motifs
| | |
|---|---|
| 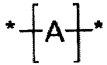 | est comprise entre 5 et 89,9 % en moles, de préférence entre 40 et 50 % en moles, |
| 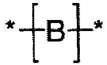 | entre 55 et 10 % en moles, de préférence entre 25 et 49 % en moles, et |
| 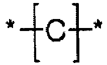 | entre 40 et 0,1 % en moles, de préférence entre 25 et 1 % en moles, |
dans chaque cas par rapport à la somme des proportions en moles de ces motifs.

4. Copolymère selon l'une des revendications précédentes, **caractérisé en ce que** les motifs 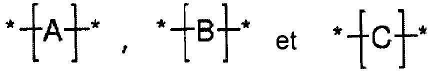 se présentent reliés comme suit 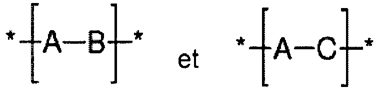 *, A, B et C ayant les significations données dans la revendication 1.

5. Copolymère selon la revendication précédente, **caractérisé en ce que** la proportion en moles du motif 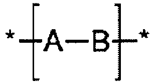 est comprise entre 99 et 30 % en moles, de préférence de 95 à 40 % en moles, d'une manière particulièrement préférée de 92,5 à 75 % en moles, et
la proportion en moles du motif 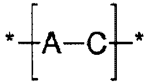 est comprise entre 1 et 70 % en moles, de préférence entre 5 et 60 % en moles, d'une manière particulièrement préférée de 7,5 et 25 % en moles, par rapport à la somme des deux motifs

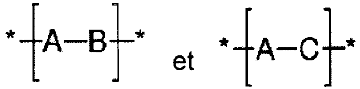

6. Copolymère selon l'une des revendications précédentes, **caractérisé en ce que** le motif thiaaromatique C représente un groupement ayant la formule présentée ci-après 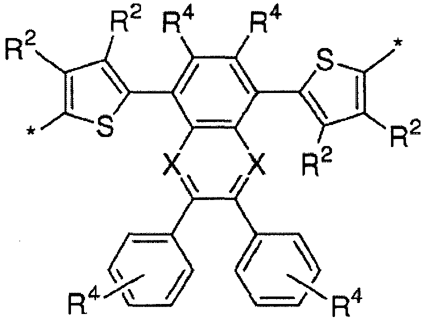 dans laquelle *, R², R⁴ et X ont les significations données ci-dessus.

7. Procédé de préparation d'un copolymère selon l'une des revendications précédentes, dans lequel
a) on polymérise un composé 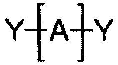 avec un mélange des composés 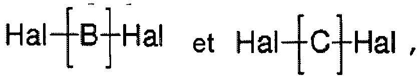 ou
b) on polymérise un composé 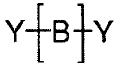 avec un mélange des composés 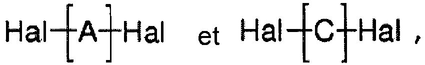 ou
c) on polymérise un composé 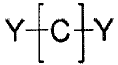 avec un mélange des composés 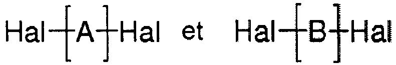 sous l'influence d'un catalyseur par couplage croisé,
Hal représentant Cl, Br, I ou un pseudo-halogène, comme par exemple le triflate ou le tosylate, et
Y représente des groupes stannyle, acide boronique, esters de l'acide boronique, ou Zn-Hal.

8. Mélange de substances comprenant un copolymère selon l'une des revendications 1 à 6 ainsi qu'un fullerène en C₆₀ et/ou en C₇₀ et/ou un dérivé de fullerène qui en dérive, en particulier PC₆₁ BM et/ou PC₇₁ BM, en particulier selon un rapport en moles (copolymère : fullerène en C₆₀ et/ou en C₇₀ et/ou un dérivé de fullerène qui en dérive) de 10:90 à 80:20, de préférence de 20:80 à 70:30.

9. Utilisation d'un copolymère selon l'une des revendications 1 à 7 ou d'un mélange de substances selon la revendication précédente en tant qu'absorbant d'un module photovoltaïque organique ou en tant que constituant semi-conducteur d'un transistor à effet de champ ou d'une diode.

10. Composant électrique ou électronique, comprenant un semi-conducteur, contenant un copolymère selon l'une des revendications 1 à 6 ou un mélange de substances selon la revendication 8, ou en étant constitué.

11. Composant selon la revendication précédente, comprenant
a) un substrat, de préférence en verre ou en des matériaux polymères tels que par exemple des polyimides, des polyalkylènes ou des polyesters,
b) une première électrode déposée sur le substrat, de préférence une électrode en oxyde d'indium et d'étain (ITO), en oxyde de zinc ou en oxyde de titane,
c) une couche déposée sur la première électrode, du copolymère ou du mélange de substances, ainsi que
d) une deuxième électrode, déposée sur la couche du copolymère ou du mélange de substances, de préférence une électrode en LiF/Al, Ca, PEDOT:PSS ou oxyde de molybdène,
e) ainsi qu'éventuellement une couche de protection déposée sur la deuxième électrode.

12. Composant selon l'une des deux revendications précédentes, **caractérisé en ce que**, entre la première électrode et la couche du copolymère ou du mélange de substances, on dépose une couche d'un polymère conducteur, en particulier le PEDOT:PSS.

13. Composant selon l'une des deux revendications précédentes, **caractérisé en ce que**
a) la couche du copolymère ou du mélange de substances présente une épaisseur de couche de 20 nm à 1 000 nm, de préférence de 50 nm à 500 nm,
b) la couche du polymère conducteur présente une épaisseur de couche de 10 à 100 nm, de préférence de 20 à 50 nm, et/ou
c) la première et/ou la deuxième électrodes présentent une épaisseur de couche de 10 à 1 000 nm, de préférence de 50 à 500 nm.

14. Composant selon l'une des revendications 11 à 13 sous forme d'un module photovoltaïque, d'un transistor à effet de champ ou d'une diode.

15. Procédé de fabrication d'un composant électrique ou électronique selon l'une des revendications 11 à 14, dans lequel
a) le copolymère selon l'une des revendications 1 à 6 ou le mélange de substances selon la revendication 8 est déposé à partir d'une solution par application à la tournette, application au trempé, application à la racle, ou par un procédé d'impression tel que le revêtement au jet d'encre ou le revêtement à la filière plate, le solvant étant ensuite éliminé, et/ou
b) on dépose en phase vapeur ou on imprime la première et/ou la deuxième électrodes, ou on les dépose à partir de composés précurseurs des matériaux d'électrode.
